# EUROPEAN PATENT SPECIFICATION

(11) **EP 3 166 374 B1**
(45) Date of publication and mention of the grant of the patent: **22.04.2020**
(21) Application number: 16183366.0
(22) Date of filing: 09.08.2016
(51) Int. Cl.: A47B 88/40, H05K 7/14

(54) **SLIDE RAIL ASSEMBLY**
GLEITSCHIENENANORDNUNG
ENSEMBLE DE RAIL DE GLISSEMENT

(30) Priority: 04.11.2015 TW 104136443
(43) Date of publication of application: 10.05.2017
(73) Proprietor: King Slide Works Co., Ltd., Kaohsiung City 821 (TW); King Slide Technology Co., Ltd., 82151 Kaohsiung City (TW)
(72) Inventor: Chen, Ken-Ching, 821 Kaohsiung City (TW); Yang, Shun-Ho, 821 Kaohsiung City (TW); Chou, Chi-Chih, 821 Kaohsiung City (TW); Wang, Chun-Chiang, 821 Kaohsiung City (TW)
(74) Representative: Straus, Alexander

(56) References cited:
- EP-A1- 2 446 779
- EP-A2- 2 464 205
- WO-A1-2014/201921
- US-A1- 2015 023 619

## Description

### Field of the Invention

The present invention is related to a slide rail assembly.

### Background of the Invention

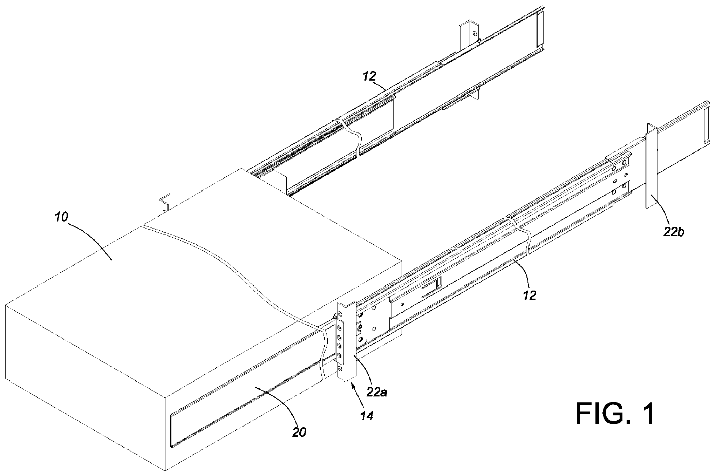

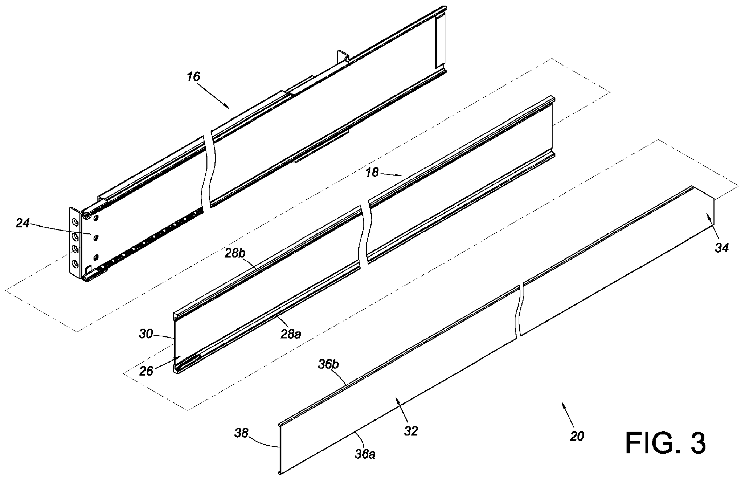

Generally, in a rack system, a carried object can be mounted to a rack by a support rail. US Patent No. 8,780,565 B2 discloses a rack system. As shown in FIG. 1 of the patent, an information handling system (10) is configured to be mounted to an inner rail member (22). Wherein, the inner rail member (22) can be inserted into an intermediate rail member (20) in order to be mounted to a slide rail subassembly (18) on a rack (12). Wherein, FIG. 3 of the patent further shows the intermediate rail member (20) having an upper portion (32) and a lower portion (30). The lower portion (30) has a resting surface (34) extending beyond the upper portion (32) a predetermined distance, such that the inner rail member (22) can rest on the resting surface (34) of the intermediate rail member (20) in order to be further mounted to the intermediate rail member (20). However, for different requirement and product diversity, slide rail assemblies with different assembly methods can be provided to bring more options to the market.

Note that, document WO 2014/201921 discloses a slide rail assembly. However, a step is formed between the extension part and the main body part of the third slide rail. Thus the extension part of the third slide rail cannot guide the main body part of the third slide rail to enter the passage of the second slide rail. Document US 2015/023619 A1 discloses a rail device. However, the extension part of the outer rail has two obliquely cut-off edges relative to the main body part of the outer rail. Therefore, the extension part of the outer rail cannot straightly guide the main body part of the outer rail to straightly enter the passage of the middle rail along the longitudinal direction of the middle rail.

### Summary of the Invention

This in mind, the present invention aims at providing a slide rail assembly for an electronic cabinet.

This is achieved by a slide rail assembly for an electronic cabinet according to claim 1. The dependent claims pertain to corresponding further developments and improvements.

As will be seen more clearly from the detailed description following below, the claimed slide rail assembly comprises a first rail and a second rail. The first rail comprises a first wall, a second wall and a longitudinal wall connected between the first wall and the second wall. A passage is defined by the first wall, the second wall and the longitudinal wall. The passage has a first height. The second rail is movable relative to the first rail. The second rail comprises a main body part and an extension part. The main body part has a second height, and an end of the extension part has a third height. Wherein, the first height of the passage of the first rail is greater than the second height of the main body part of the second rail, and the second height of the main body part of the second rail is greater than the third height of the end of the extension part. Wherein, the extension part is configured to be operatively placed into the passage of the first rail to directly contact the first wall of the first rail, in order to guide the main body part of the second rail to enter the passage of the first rail thereafter. Wherein, the main body part of the second rail comprises a first wall straightly elongated along a longitudinal direction of the second rail, a second wall straightly elongated along the longitudinal direction of the second rail, and a longitudinal wall connected between the first wall and the second wall, the first wall of the second rail is straightly extended from the main body part to the end of the extension part along the longitudinal direction of the second rail, the second wall of the second rail is not extended to the extension part.

### Brief Description of the Drawings

In the following, the invention is further illustrated by way of example, taking reference to the accompanying drawings thereof:
FIG. 1 is a diagram showing slide rail assemblies configured to mount a carried object to a rack according to an embodiment of the present invention;
FIG. 2 is a diagram showing the slide rail assembly according to an embodiment of the present invention;
FIG. 3 is an exploded view of the slide rail assembly according to an embodiment of the present invention;
FIG. 4 is a diagram showing a second rail of the slide rail assembly being going to be mounted to a first rail according to an embodiment of the present invention;
FIG. 5 is a diagram showing an extension part of the second rail of the slide rail assembly entering into a passage of the first rail according to an embodiment of the present invention;
FIG. 6 is a diagram showing a main body part of the second rail of the slide rail assembly entering into the passage of the first rail according to an embodiment of the present invention;
FIG. 7 is a diagram showing the extension part of the second rail of the slide rail assembly being supported by the first rail according to an embodiment of the present invention;
FIG. 8 is a diagram showing the second rail of the slide rail assembly entering into the passage of the first rail through guiding of a guiding surface of the extension part according to an embodiment of the present invention; and
FIG.9 is a diagram showing a slide rail assembly according to another embodiment of the present invention.

### Detailed Description

FIG. 1 is a diagram showing a carried object 10 mounted to a rack 14 through a pair of slide rail assemblies 12 according to an embodiment of the present invention. Specifically, the carried object 10 can be an electronic device or a chassis.

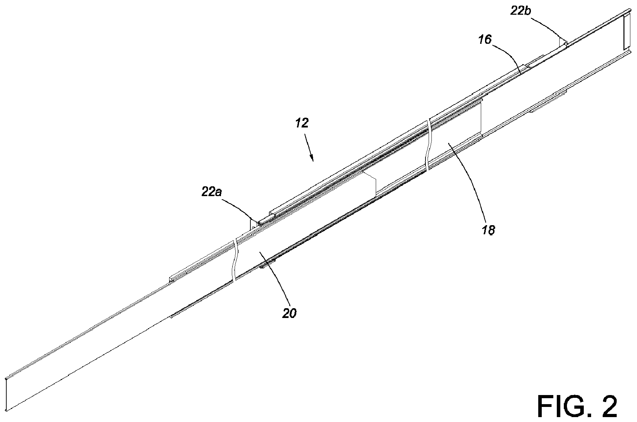

As shown in FIG. 1 and FIG. 2, each of the slide rail assemblies 12 comprises a support rail 16, a first rail 18 and a second rail 20. Wherein, the support rail 16 is mounted between a first post 22a and a second post 22b of the rack 14. The second rail 20 is configured to carry the carried object 10. The first rail 18 and the second rail 20 are movable relative to the support rail 16, such as being moved to switch from a retracted state to an extending state, so as to allow the carried object 10 to be moved from the inside of the rack 14 to the outside of the rack 14.

As shown in FIG. 3, the support rail 16 comprises a supporting passage 24 configured to accommodate the first rail 18. The first rail 18 comprises a passage 26. Specifically, the first rail 18 comprises a first wall 28a, a second wall 28b and a longitudinal wall 30 connected between the first wall 28a and the second wall 28b. The passage 26 is defined by the first wall 28a, the second wall 28b and the longitudinal wall 30, and configured to accommodate the second rail 20.

The second rail 20 comprises a main body part 32 and an extension part 34. Specifically, the main body part 32 of the second rail 20 comprises a first wall 36a, a second wall 36b and a longitudinal wall 38 connected between the first wall 36a and the second wall 36b.

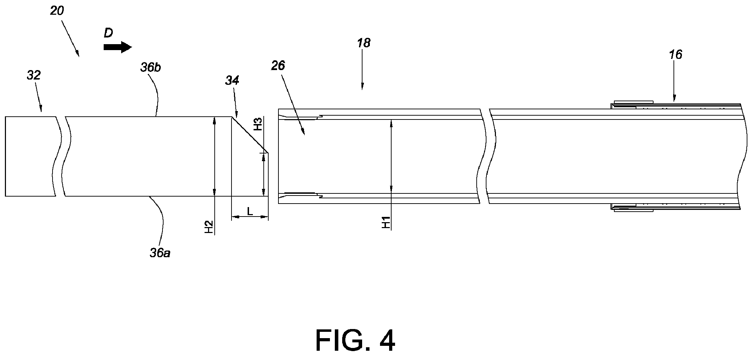

As shown in FIG. 4, the first rail 18 is movably mounted to the support rail 16. The passage 26 of the first rail 18 has a first height H1. The main body part 32 of the second rail 20 has a second height H2. An end of the extension part 34 has a third height H3. Wherein, the first height H1 of the passage 26 of the first rail 18 is greater than the second height H2 of the main body part 32 of the second rail 20. The second height H2 of the main body part 32 of the second rail 20 is greater than the third height H3 of the end of the extension part 34. The first wall 36a of the second rail 20 extends beyond the second wall 36b of the second rail 20 a predetermined distance L along with the extension part 34. In other words, the first wall 36a of the second rail 20 is longer than the second wall 36b of the second rail 20.

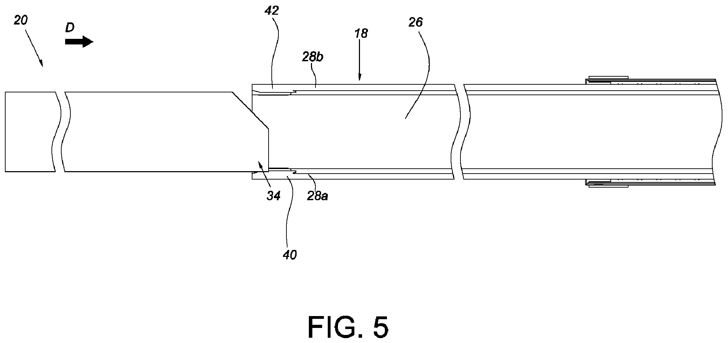

As shown in FIG. 4 and FIG. 5, during a mounting process, a user can mount the second rail 20 into the passage 26 of the first rail 18 along a direction D. In such process, the extension part 34 is configured to be operatively placed into the passage 26 of the first rail 18 and supported by the first wall 28a of the first rail 18. Therefore, the second rail 20 can be rapidly aligned to the passage 26 of the first rail 18, in order to facilitate mounting the second rail 20 into the passage 26 of the first rail 18. Preferably, the slide rail assembly 12 further comprises a first supporting member 40 and a second supporting member 42 respectively arranged on the first wall 28a and the second wall 28b within the passage 26 of the first rail 18. The first supporting member 40 and the second supporting member 42 are configured to guide or support the second rail 20. In the present embodiment, the extension part 34 of the second rail 20 can be supported by the first supporting member 40 on the first wall 28a of the first rail 18.

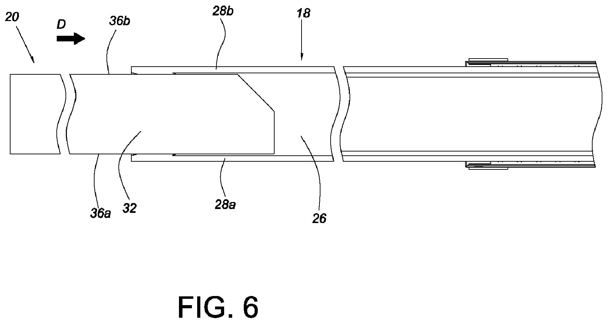

As shown in FIG. 5 and FIG. 6, when the second rail 20 is further moved relative to the first rail 18 along the direction D, the main body part 32 of the second rail 20 enters into the passage 26 of the first rail 18. Wherein, when the main body part 32 of the second rail 20 enters into the passage 26 of the first rail 18, the first wall 36a and the second wall 36b of the main body part 32 of the second rail 20 respectively correspond to the first wall 28a and the second wall 28b of the first rail 18.

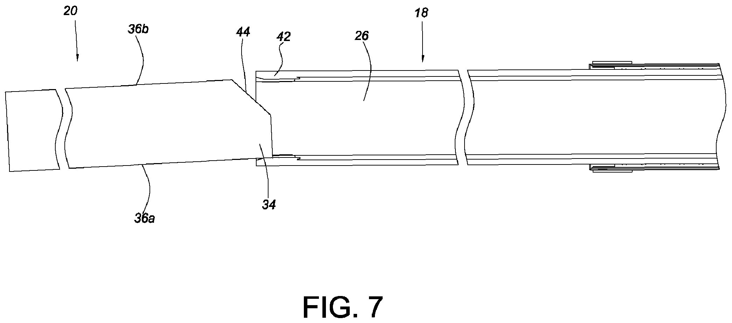

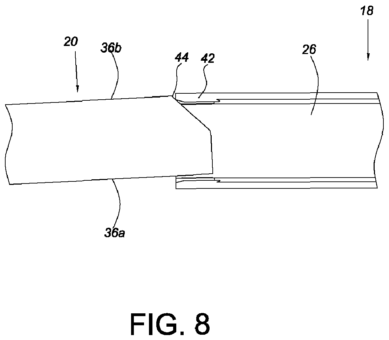

As shown in FIG. 7 and FIG. 8, the extension part 34 of the second rail 20 further comprises a guiding surface 44 located between the first wall 36a and the second wall 36b of the second rail 20. The guiding surface 44 can be an inclined surface or a curved surface. In the process of mounting the second rail 20 into the passage 26 of the first rail 18, if the second rail 20 is tilted relative to the first rail 18, the second rail 20 can be guided by the guiding surface 44 to enter the passage 26 of the first rail 18.

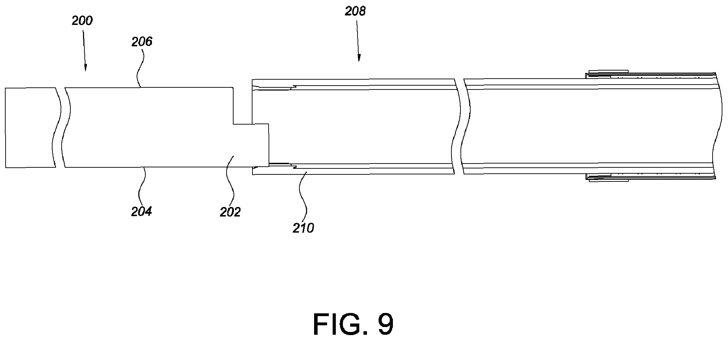

FIG. 9 is a diagram showing a related solution with an alternative shape of the second rail 200. A difference between the present solution and the claimed solution is that the second rail 200 has an L shaped end portion. For example, the extension part 202 evenly extends beyond the second wall 206 of the second rail 200 a predetermined distance as well as the first wall 204 of the second rail 200, such that the first wall 204 of the second rail 200 is longer than the second wall 206 of the second rail 200. Therefore, during a mounting process, the second rail 200 can be supported by the first wall 210 of the first rail 208 through the extension part 202.

## Claims

1. A slide rail assembly (12) for an electronic cabinet, comprising:
a first rail (18, 208) comprising a first wall (28a, 210), a second wall (28b) and a longitudinal wall (30) connected between the first wall (28a, 210) and the second wall (28b), a passage (26) being defined by the first wall (28a, 210), the second wall (28b) and the longitudinal wall (30), the passage (26) having a first height; and
a second rail (20, 200) movable relative to the first rail (18, 208), the second rail (20, 200) comprising a main body part (32) and an extension part (34, 202), the main body part (32) having a second height, an end of the extension part (34, 202) having a third height;
wherein the first height of the passage (26) of the first rail (18, 208) is greater than the second height of the main body part (32) of the second rail (20, 200), and the second height of the main body part (32) of the second rail (20, 200) is greater than the third height of the end of the extension part (34, 202);
wherein the extension part (34, 202) is configured to be operatively placed into the passage (26) of the first rail (18, 208) to directly contact the first wall (28a, 210) of the first rail (18, 208), in order to guide the main body part (32) of the second rail (20, 200) to enter the passage (26) of the first rail (18, 208).
**characterized by**:
wherein the main body part (32) of the second rail (20, 200) comprises a first wall (36a, 204) straightly elongated along a longitudinal direction of the second rail (20, 200), a second wall (36b, 206) straightly elongated along the longitudinal direction of the second rail (20, 200), and a longitudinal wall (38) connected between the first wall (36a, 204) and the second wall (36b, 206), the first wall (36a, 204) of the second rail (20, 200) is straightly extended from the main body part (32)to the end of the extension part (34, 202) along the longitudinal direction of the second rail (20, 200), the second wall (36b, 206) of the second rail (20, 200) is not extended to the extension part (34, 202);
wherein the extension part (34) comprises a guiding surface (44) located between the first wall (36a) and the second wall (36b) of the second rail (20), and the guiding surface (44) is an inclined surface or a curved surface.

2. The slide rail assembly of claim 1, further **characterized by** a first supporting member (40) arranged on the first wall (28a, 210) within the passage (26) of the first rail (18, 208) and configured to guide the second rail (20, 200).

3. The slide rail assembly of claim 2, further **characterized by** a second supporting member (42) arranged on the second wall (28b) within the passage (26) of the first rail (18, 208) and configured to guide the second rail (20, 200).

## Patentansprüche

1. Gleitschienenaufbau (12) für einen elektronischen Schrank, welcher umfasst:
eine erste Schiene (18, 208), die umfasst, eine erste Wand (28a, 210), eine zweite Wand (28b) und eine Längswand (30), die zwischen der ersten Wand (28a, 210) und der zweiten Wand (28b) verbunden ist, worin durch die erste Wand (28a, 210), die zweite Wand (28b) und die Längswand (30) eine Passage (26) definiert wird, worin die Passage (26) eine erste Höhe aufweist; und
eine zweite Schiene (20, 200), die relativ zu der ersten Schiene (18, 208) bewegbar ist, worin die zweite Schiene (20, 200) einen Hauptkörperteil (32) und ein Erstreckungsteil (34, 202) umfasst, worin der Hauptkörperteil (32) eine zweite Höhe aufweist, worin ein Ende des Erstreckungsteils (34, 202) eine dritte Höhe aufweist;
worin die erste Höhe der Passage (26) der ersten Schiene (18, 208) größer ist als die zweite Höhe des Hauptkörperteils (32) der zweiten Schiene (20, 200), und worin die zweite Höhe des Hauptkörperteils (32) der zweiten Schiene (20, 200) größer ist als die dritte Höhe des Endes des Erstreckungsteils (34, 202);
worin das Erstreckungsteil (34, 202) ausgestaltet ist, betriebsbereit in der Passage (26) der ersten Schiene (18, 208) angeordnet zu werden, um direkt mit der ersten Wand (28a, 210) der ersten Schiene (18, 208) in Kontakt zu treten, um das Hauptkörperteil (32) der zweiten Schiene (20, 200) zu führen, in die Passage (26) der ersten Schiene (18, 208) zu gelangen,
**dadurch gekennzeichnet, dass**:
dass das Hauptkörperteil (32) der zweiten Schiene (20, 200) umfasst, eine erste Wand (36a, 204), die entlang einer Längsrichtung der zweiten Schiene (20, 200) gerade verlängert ist, eine zweite Wand (36b, 206), die entlang einer Längsrichtung der zweiten Schiene (20, 200) gerade verlängert ist, und eine Längswand (38), die zwischen der ersten Wand (36a, 204) und der zweiten Wand (36b, 206) verbunden ist, worin sich die erste Wand (36a, 204) der zweiten Schiene (20, 200) von dem Hauptkörperteil (32) zu dem Ende der Erstreckungsteils (34, 202) entlang der Längsrichtung der zweiten Schiene (20, 200) gerade erstreckt, worin sich die zweite Wand (36b, 206) der zweiten Schiene (20, 200) nicht zu dem Erstreckungsteil (34, 202) erstreckt;
worin das Erstreckungsteil (34) eine Führungsfläche (44) umfasst, die zwischen der ersten Wand (36a) und der zweiten Wand (36b) der zweiten Schiene (20) vorgesehen ist, worin die Führungsfläche (44) eine geneigte Oberfläche oder eine gekrümmte Oberfläche ist.

2. Gleitschienenaufbau nach Anspruch 1, weiter **gekennzeichnet durch** ein erstes Trägerelement (40), das an der ersten Wand (28a, 210) in der Passage (26) der ersten Schiene (18, 208) vorgesehen und ausgestaltet ist, die zweite Schiene (20, 200) zu führen.

3. Gleitschienenaufbau nach Anspruch 2, weiter **gekennzeichnet durch** ein zweites Trägerelement (42), das an der zweiten Wand (28b) in der Passage (26) der ersten Schiene (18, 208) vorgesehen und ausgestaltet ist die zweite Schiene (20, 200) zu führen.

## Revendications

1. Ensemble rail coulissant(12) pour une armoire électronique, comprenant :
un premier rail (18, 208) comprenant une première paroi (28a, 210), une deuxième paroi (28b) et une paroi longitudinale (30) reliée entre la première paroi (28a, 210) et la deuxième paroi (28b), un passage (26) étant défini par la première paroi (28a, 210), la deuxième paroi (28b) et la paroi longitudinale (30), le passage (26) présentant une première hauteur ; et
un deuxième rail (20, 200) mobile par rapport au premier rail (18, 208), le deuxième rail (20, 200) comprenant une partie de corps principal (32) et une partie d'extension (34, 202), la partie de corps principal (32) présentant une deuxième hauteur, une extrémité de la partie d'extension (34, 202) présentant une troisième hauteur ;
la première hauteur du passage (26) du premier rail (18, 208) étant supérieure à la deuxième hauteur de la partie de corps principal (32) du deuxième rail (20, 200) et la deuxième hauteur de la partie de corps principal (32) du deuxième rail (20, 200) étant supérieure à la troisième hauteur de l'extrémité de la partie d'extension (34, 202) ;
la partie d'extension (34, 202) étant conçue pour être placée de manière fonctionnelle dans le passage (26) du premier rail (18, 208) pour entrer en contact direct avec la première paroi (28a, 210) du premier rail (18, 208), afin de guider la partie de corps principal (32) du deuxième rail (20, 200) pour qu'il entre dans le passage (26) du premier rail (18, 208). **caractérisé en ce que** :
la partie de corps principal (32) du deuxième rail (20, 200) comprend une première paroi (36a, 204) allongée de manière rectiligne le long d'une direction longitudinale du deuxième rail (20, 200), une deuxième paroi (36b, 206) allongée de manière rectiligne le long de la direction longitudinale du deuxième rail (20, 200) et une paroi longitudinale (38) reliée entre la première paroi (36a, 204) et la deuxième paroi (36b, 206), la première paroi (36a, 204) du deuxième rail (20, 200) étant étendue de manière rectiligne depuis la partie de corps principal (32) jusqu'à l'extrémité de la partie d'extension (34, 200) le long de la direction longitudinale du deuxième rail (20, 200), la deuxième paroi (36b, 206) du deuxième rail (20, 200) n'étant pas étendue jusqu'à la partie d'extension (34, 202) ;
la partie d'extension (34) comprend une surface de guidage (44) située entre la première paroi (36a) et la deuxième paroi (36b) du deuxième rail (20) et la surface de guidage (44) étant une surface inclinée ou une surface incurvée.

2. Ensemble rail coulissant selon la revendication 1, **caractérisé en outre par** un premier élément de support (40) disposé sur la première paroi (28a, 210) à l'intérieur du passage (26) du premier rail (18, 208) et conçu pour guider le deuxième rail (20, 200).

3. Ensemble rail coulissant selon la revendication 2, **caractérisé en outre par** un deuxième élément de support (42) disposé sur la deuxième paroi (28b) à l'intérieur du passage (26) du premier rail (18, 208) et conçu pour guider le deuxième rail (20, 200).
